# EUROPÄISCHE PATENTANMELDUNG

(11) **EP 3 926 421 A1**
(43) Veröffentlichungstag der Anmeldung: **22.12.2021**
(21) Anmeldenummer: 20180251.9
(22) Anmeldetag: 16.06.2020
(51) Int. Cl.: G05B 17/02, B25J 9/16, G05B 19/418, G06F 30/20

(54) **VERFAHREN UND SIMULATIONSVORRICHTUNG ZUR SIMULATION EINER PRODUKTIONSMASCHINE**

(71) Anmelder: Siemens Aktiengesellschaft, 80333 München (DE)
(72) Erfinder: Bergmann, Dominik, 83679 Sachsenkam (DE); Bischoff, Martin, 85653 Aying, Großhelfendorf (DE); Gerlich, Matthias, 80636 München (DE)

(57) **Zusammenfassung**

Der Kerngedanke der vorliegenden Offenbarung besteht also darin, bei der Entwicklung einer Produktionsmaschine eine Multikriterien-Optimierung basierend auf einer Multi-Domänen-Simulation durchzuführen. Ein wesentliches Merkmal der Erfindung ist, dass die Simulation der Produktionsmaschine gleichzeitig in wenigstens zwei physikalischen Domänen erfolgt, nämlich zumindest in der mechanischen Domäne und in der elektronischen Signal-Domäne.

Es wird ein computergestütztes Verfahren zur Multi-Domänen-Simulation einer Mehrzahl von technischen Zielgrößen einer Produktionsmaschine (1) angegeben, welche einen Manipulator (10), eine Antriebseinrichtung (30) und eine Ansteuerungseinrichtung (20) aufweist, wobei das Verfahren die folgenden Verfahrensschritte umfasst:

a1) Bereitstellen einer ersten Modellkomponente (M1), welche eine oder mehrere mechanische Eigenschaften des Manipulators (10) und/oder der Antriebseinrichtung (30) als Funktion eines ersten Parametersatzes (P1) beschreibt, in einer ersten Entwicklungsumgebung (E1),

a2) Bereitstellen einer zweiten Modellkomponente (M2), welche eine oder mehrere physikalische Eigenschaften der Ansteuerungseinrichtung (20) als Funktion eines zweiten Parametersatzes beschreibt (P2), in einer zweiten Entwicklungsumgebung (E2),

b) Bereitstellen der ersten und der zweiten Modellkomponente (M1,M2) in einer Gesamt-Simulationsanwendung (G) und

c) Simulation eines Ergebnis-Datensatzes mit einer Mehrzahl der technischen Zielgrößen der Produktionsmaschine (1) in der Gesamt-Simulationsanwendung (G) auf Basis der Modellkomponenten (M1,M2), wobei Schritt c) mit unterschiedlichen Parametersätzen (P1,P2) mehrfach wiederholt wird, so dass für jeden Parametersatz (P1,P2) ein zugeordneter Ergebnis-Datensatz mit einer Mehrzahl von technischen Zielgrößen erhalten wird.

## Beschreibung

Die vorliegende Erfindung betrifft ein Verfahren, ein Computerprogrammprodukt und eine Simulationsvorrichtung zur Simulation von technischen Zielgrößen einer Produktionsmaschine, welche einen Manipulator, wenigstens eine Antriebseinrichtung und wenigstens eine Ansteuerungseinrichtung umfasst.

Bei der Entwicklung von Maschinen und insbesondere industriellen Produktionsmaschinen wird heutzutage oft nicht nur die reale physische Maschine, sondern auch eine computergestützte Simulation der Maschine betrachtet. So werden grundsätzlich bekannte computergestützte Simulationsumgebungen eingesetzt, um beispielsweise die mechanischen Parameter eines Roboterarms, die mechanischen und elektromagnetischen Parameter der Antriebseinrichtung und die physikalischen Parameter der Ansteuerungseinrichtung zu optimieren. Die Optimierung der gesamten Produktionsmaschine mit ihren einzelnen Teilkomponenten kann dabei grundsätzlich an sehr unterschiedlichen Entwicklungszielen ausgerichtet sein. Die Zielgrößen unterscheiden sich dabei zum Teil deutlich, abhängig von der genauen Anwendung der Produktionsmaschine in einem gegebenen Produktionsprozess. Insbesondere müssen dabei von den Entwicklungsingenieuren meist mehrere unterschiedliche technische Zielgrößen betrachtet werden, für die nicht gleichzeitig ein Optimum erreicht werden kann. Beispielsweise soll häufig eine hohe mechanische Stabilität, aber gleichzeitig eine geringe Masse der Produktionsmaschine erreicht werden. Diese beiden Zielkriterien konkurrieren aber miteinander, da die Wahl von besonders leichten Materialien und schlanken Bauelementen häufig eine geringe Stabilität zur Folge hat. In ähnlicher Weise konkurriert das Entwicklungsziel eines niedrigen Energieverbrauchs mit dem Ziel einer hohen Performance, beispielsweise in Bezug auf eine hohe Kraft, ein hohes Drehmoment, eine hohe Bewegungsgeschwindigkeit, eine hohe Beschleunigung und/oder eine hohe Positioniergenauigkeit. In ähnlicher Weise konkurriert auch allgemein das Entwicklungsziel von niedrigen Produktionskosten mit dem Entwicklungsziel einer hohen Qualität und/oder einer langen Lebensdauer bzw. langen Wartungsintervallen einer solchen Produktionsmaschine.

Die Optimierung von Produktionsmaschinen im Hinblick auf mehrere grundsätzlich miteinander konkurrierende Entwicklungsziele wird in der Praxis häufig auch dadurch erschwert, dass das Gesamtsystem der Produktionsmaschine sehr komplex ist. Es umfasst zum einen die mechanischen Komponenten des Manipulators und des Antriebssystems. Das Antriebssystem weist zusätzlich auch elektromagnetische Komponenten auf, wie beispielsweise einen Antriebsmotor oder auch eine elektromagnetische Bremse. Zusätzlich wird für die Optimierung der Ansteuerungseinrichtung von den Entwicklern technisches Wissen im Bereich der Informatik, Kommunikation und Signalübertragung benötigt. Es handelt sich also insgesamt bei der Optimierung einer solchen Produktionsmaschine um eine äußerst komplexe Aufgabe, an der Entwicklerteams mit Experten aus unterschiedlichen technischen Fachbereichen beteiligt sind. Ein wesentlicher Nachteil bekannter Entwicklungsmethoden besteht darin, dass häufig jeder Fachexperte nur mit der Optimierung seines eigenen Teilbereichs befasst ist. So optimiert z.B. ein Antriebsentwickler typischerweise die technischen Parameter der Antriebseinrichtung, ohne ein tiefes Fachwissen über die Optimierungsmöglichkeiten im Bereich der Ansteuerungstechnik zu besitzen. In ähnlicher Weise optimiert z.B. ein Programmierer isoliert die Eigenschaften der Ansteuerungseinrichtung. Die Vorteile der einzelnen Optimierungen in Bezug auf die Eigenschaften des Gesamtsystems werden häufig erst beim Zusammenfügen der einzelnen Komponenten abschätzbar.

Aufgabe der Erfindung ist es daher, ein Simulationsverfahren anzugeben, welches die genannten Nachteile überwindet. Insbesondere soll ein Simulationsverfahren zur Verfügung gestellt werden, welches die Optimierung der Auslegungsparameter einer Produktionsmaschine im Hinblick auf die dort auftretenden komplexen technischen Zusammenhänge erleichtert. Eine weitere Aufgabe ist es, ein Computerprogrammprodukt sowie eine Simulationsvorrichtung für eine solche Simulation einer Produktionsmaschine zur Verfügung zu stellen.

Diese Aufgaben werden durch das in Anspruch 1 beschriebene computergestützte Verfahren, das in Anspruch 14 beschriebene Computerprogrammprodukt und die in Anspruch 15 beschriebene Simulationsvorrichtung gelöst.

Das computergestützte Verfahren dient zur Simulation einer Mehrzahl von technischen Zielgrößen einer Produktionsmaschine. Diese Produktionsmaschine umfasst einen Manipulator, wenigstens eine Antriebseinrichtung und wenigstens eine Ansteuerungseinrichtung. Das Verfahren umfasst die folgenden Verfahrensschritte:
a1) Bereitstellen einer ersten Modellkomponente, welche ein oder mehrere mechanische Eigenschaften des Manipulators und/oder der Antriebseinrichtung als Funktion eines ersten Parametersatzes beschreibt, in einer ersten Entwicklungsumgebung,
a2) Bereitstellen einer zweiten Modellkomponente, welche ein oder mehrere physikalische Eigenschaften der Ansteuerungseinrichtung als Funktion eines zweiten Parametersatzes beschreibt, in einer zweiten Entwicklungsumgebung,
b) Bereitstellen der ersten und der zweiten Modellkomponente in einer Gesamt-Simulationsanwendung und
c) Simulation eines Ergebnis-Datensatzes mit einer Mehrzahl der technischen Zielgrößen der Produktionsmaschine in der Gesamt-Simulationsanwendung auf Basis der Modellkomponenten.

Dabei wird Schritt c) mit unterschiedlichen Parametersätzen mehrfach wiederholt, so dass für jeden Parametersatz ein zugeordneter Ergebnis-Datensatz mit einer Mehrzahl von technischen Zielgrößen erhalten wird.

Die von der Simulation zu betrachtende Produktionsmaschine ist allgemein eine Maschine für ein industrielles Produktionsumfeld, insbesondere ein industrieller Roboter oder ein Teil eines solchen Roboters, also beispielsweise ein Roboterarm. Es soll sich also insbesondere um eine automatisierbare Produktionsmaschine handeln, welche über die integrierte Antriebseinrichtung und die integrierte Ansteuerungseinrichtung automatisiert bewegt werden kann. Dabei kann eine solche Produktionsmaschine bzw. ein solcher Roboter grundsätzlich für eine Vielzahl von Aufgaben ausgelegt sein. So kann die Maschine beispielsweise zur Bearbeitung von Bauelementen z.B. durch Fertigungs- und Materialbearbeitungsverfahren wie Schweißen, Zerteilen, Gravieren usw. ausgelegt sein. Sie kann aber auch zur Durchführung von Positionieraufgaben ausgelegt sein, also zur Bewegung von Objekten im Raum, z.B. für eine Werkstückzufuhr in einem Bearbeitungszentrum. Die Maschine kann entweder nur zur Positionierung ausgelegt sein, oder die Positionierung kann wahlweise auch mit einer Bearbeitung durch dieselbe Maschine kombiniert werden. Alternativ oder zusätzlich kann die Maschine auch zur Durchführung von Messaufgaben ausgelegt sein. All diese Anwendungsformen sind nur beispielhaft zu verstehen und sollen die Bandbreite an möglichen automatisierbaren Produktionsmaschinen verdeutlichen. Allen diesen Anwendungen ist gemeinsam, dass typischerweise ein Bearbeitungsmittelpunkt (TCP für englisch "tool center point") durch verschiedene Posen der Maschine automatisiert im Raum platziert wird. Unter diesen Posen werden allgemein die vorgegebenen Positionierungen und Orientierungen des TCP im Raum verstanden. Um diese automatisierte Bewegung zu ermöglichen, weist eine solche Produktionsmaschine zumindest einen translatorischen und/oder rotatorischen Bewegungsfreiheitsgrad für eine automatisiert durchzuführende Bewegung auf. Dies kann durch ein oder mehrere Dreh- und/oder Schubachsen erreicht werden, wobei durch die Kombination der einzelnen Bewegungen eine Gesamtbewegung des TCP im Raum erreicht wird. Im Bereich des TCP weist eine solche Produktionsmaschine typischerweise einen Endeffektor auf, mit welchem ein Objekt gegriffen, bearbeitet und/oder gemessen werden kann.

In jedem Fall und unabhängig von der genauen Ausführung weist die Produktionsmaschine einen Manipulator, zumindest eine Antriebseinrichtung und zumindest eine Ansteuerungseinrichtung auf. Unter dem Manipulator wird allgemein der bewegliche Teil der Maschine verstanden, der die mechanische Arbeit der Maschine ausführt. Die wenigstens eine Antriebseinrichtung der Maschine ist dazu ausgelegt, die mechanische Bewegung des Manipulators zu bewirken. Sie kann insbesondere ein Teilelement des Manipulators sein, also in diesen integriert sein. Jede der vorhandenen Antriebseinrichtungen kann insbesondere einer bestimmten Drehachse oder Rotationsachse zugeordnet sein. Es kann sich dann entsprechend um Rotationsantriebe oder Linearantriebe handeln. Insbesondere kann für jeden vorhandenen Bewegungsfreiheitsgrad eine zugeordnete Antriebseinrichtung vorgesehen sein. Jede solche Antriebseinrichtung kann ihrerseits eine Vielzahl von Teilelementen umfassen, beispielsweise einen Antriebsmotor, eine Antriebswelle und optionale Elemente wie beispielsweise ein Getriebe, eine Bremseinrichtung und ein oder mehrere Sensoren. Die Ansteuerungseinrichtung dient zur automatischen Ansteuerung der einzelnen Antriebe. Es kann sich dabei um eine zentrale Ansteuerungseinrichtung oder auch um mehrere dezentrale Ansteuerungseinrichtungen handeln. Eine einzelne Ansteuerungseinrichtung kann ein oder mehrere elektronische Bauelemente umfassen, beispielsweise eine speicherprogrammierbare Steuerung (PLC für englisch "programmable logic controller"), eine Steuerplatine, einen oder mehrere Umrichter, ein oder mehrere Ausleseelemente für die vorhandenen Sensoren und/oder eine Kommunikationsschnittstelle.

Die genannten technischen Zielgrößen sind insbesondere die Optimierungskriterien, anhand derer von einem Entwickler bzw. einem Entwicklerteam eine bestimmte Auslegung einer Produktionsmaschine vorgenommen wird. Allgemein können mit Hilfe der Simulation auch nur die Zielgrößen einer Teilkomponente der Produktionsmaschine simuliert werden, wodurch dann auf die Zielgrößen der gesamten Produktionsmaschine geschlossen werden kann. Wesentlich ist aber, dass zumindest ein Teil der technischen Zielgrößen sowohl durch den ersten Parametersatz als auch durch den zweiten Parametersatz beeinflussbar sind, also von beiden Parametersätzen abhängen. Dies wird bei der Simulation durch die Kombination der beiden Modellkomponenten in der Gesamt-Simulationsanwendung abgebildet. Dabei beschreibt die erste Modellkomponente die mechanischen Eigenschaften der wesentlichen mechanischen Teilelemente der Produktionsmaschine, nämlich des Manipulators und/oder der Antriebseinrichtung. Zumindest eines dieser grundlegenden mechanischen Bauelemente soll bezüglicher seiner mechanischen Eigenschaften in der ersten Modellkomponente modelliert werden. Besonders vorteilhaft kann die erste Modellkomponente auch die mechanischen Eigenschaften für die Kombination aus Manipulator und Antriebseinrichtung beschreiben. Die zweite Modellkomponente beschreibt dagegen die physikalischen Eigenschaften der Ansteuerungseinrichtung, also insbesondere die Charakteristika von Signalflüssen, Datenflüssen und hardware- oder software-implementierten Steuerungs- und/oder Regelungsmechanismen inklusive deren Schwellwerten und Anpassungswerten.

Ein wesentliches Merkmal der Erfindung ist also, dass die Simulation der Produktionsmaschine gleichzeitig in wenigstens zwei physikalischen Domänen erfolgt, nämlich zumindest in der mechanischen Domäne und in der elektronischen Signal-Domäne. Optional können noch weitere Domänen hinzutreten, oder es kann eine der bereits beschriebenen Domänen aus weiteren Teil-Domänen zusammengesetzt sein. So kann beispielsweise die Ansteuerung auf verschiedenen Levels entwickelt und programmiert werden, welche dann jeweils einer solchen Teil-Domäne entsprechen.

Die einzelnen Domänen werden jeweils über eigene Modellkomponenten beschrieben, welche aber in einer übergeordneten Gesamt-Simulationsanwendung zusammengefügt werden, so dass die Berechnung von übergeordneten technischen Zielgrößen ermöglicht wird, welche von Parametern aus beiden Domänen abhängen. So kann beispielsweise ein Antriebs-Entwickler neben der Abhängigkeit von den Parametern der Antriebseinrichtung auch die Abhängigkeit von den Parametern der mechanischen Auslegung des Manipulators oder den Ansteuerungs-Parametern untersuchen und visualisieren. Ähnliches gilt für die anderen technischen Experten. Dies gilt insbesondere für Variationsmöglichkeiten in den jeweils anderen Domänen, welche noch weit weg von der fertigen Maschine sind und somit einem frühen Entwicklungsstadium entsprechen. Jedem Teil-Entwickler wird somit ermöglicht, einen Überblick über die Abhängigkeit der Gesamt-Zielgrößen von dem zur Verfügung stehenden Parameterfeld, nicht nur für die eigene technische Domäne, sondern auch für die übrigen Domänen zu erhalten. Damit werden der Ansatz und die Vorteile der kontinuierlichen Integration von der Software-Entwicklung auf die Modellbeschreibung einer Produktionsmaschine übertragen.

Bei den Parametersätzen der einzelnen Domänen (hier also dem ersten und zweiten Parametersatz) kann es sich dabei insbesondere um Eingabe-Parametersätze handeln. Die Eingabe dieser Parameter kann beispielsweise manuell, also durch eine Interaktion des Anwenders, erfolgen. Alternativ kann sie aber beispielsweise auch durch einen automatisierten Import von Daten (z.B. aus einem anderen Modell) erfolgen, so dass ein menschliches Handeln für die Eingabe der Parameter nicht unbedingt erforderlich ist. Wesentlich ist nur, dass die Parametersätze der beiden Modellkomponenten im Rahmen der Simulation variiert werden, so dass die berechneten technischen Zielgrößen in Abhängigkeit von diesen beiden Parametersätzen erhalten werden. Dabei soll zumindest einer der beiden Parametersätze verändert werden. Besonders vorteilhaft werden aber sowohl Parameter des ersten Parametersatzes als auch Parameter des zweiten Parametersatzes verändert, und der Ergebnis-Datensatz wird als Funktion dieser veränderten Parameter erhalten.

Wesentlich im Zusammenhang mit der vorliegenden Erfindung ist weiterhin, dass mit der Simulation eine Mehrzahl von technischen Zielgrößen berechnet wird, sodass durch die Simulation eine Multikriterien-Optimierung ermöglicht wird. Der Kerngedanke der vorliegenden Erfindung besteht also darin, bei der Entwicklung einer Produktionsmaschine eine Multikriterien-Optimierung basierend auf einer Multi-Domänen-Simulation durchzuführen. Damit erhält der Entwickler aus jeder Domäne einen frühen Zugriff auf den Entwicklungsstand und die verbleibenden Variationsmöglichkeiten aus den übrigen Domänen, ähnlich wie bei der kontinuierlichen Integration in der Software-Programmierung. Die Festlegung auf eine bestimmte Auslegung des Gesamtsystems, also mit anderen Worten die optimierte Auslegung der Produktionsmaschine kann dabei trotzdem manuell, also durch eine menschliche Entscheidung eines Entwicklers oder Entwicklerteams erfolgen. Die Simulation stellt lediglich einen Lösungsraum mit einer Menge von vorteilhaften Lösungsmöglichkeiten zur Verfügung, aus denen der Entwickler eine in Anbetracht der konkurrierenden Zielgrößen die subjektiv beste Lösung auswählen kann. Mit anderen Worten wird mit dem beschriebenen Verfahren eine multikriterielle Pareto-Optimierung unterstützt, indem eine Menge von möglichen und insbesondere günstigen Parameterkombinationen berechnet wird. Bei der Menge der ermittelten Lösungen es sich allgemein besonders vorteilhaft um eine Pareto-Menge handeln, also um eine Menge von Parameterkombinationen, bei dem eine Verbesserung bezüglich einer Zielgröße nur durch Verschlechterung bezüglich einer anderen Zielgröße erreicht werden kann.

Durch die Berechnung und Ausgabe einer solchen Lösungsmenge kann die Entwicklung einer komplexen Produktionsmaschine wesentlich erleichtert werden. Dabei kann der Aufwand für die Entwicklung im Vergleich zu herkömmlichen Methoden deutlich verringert werden, da ein Entwickler für eine Domäne bereits in einem frühen Stadium den Möglichkeitenraum aus einer anderen Domäne für die Gesamt-Optimierung nutzen kann. Gleichzeitig kann das Auffinden eines Gesamt-Optimums im Hinblick auf die konkurrierenden Ziele derart verbessert werden, dass bei einer gegebenen Gewichtung der Teilziele sogar eine verbesserte Gesamt-Performance erreicht werden kann.

Allgemein soll im Zusammenhang mit der vorliegenden Erfindung unter dem Begriff "Optimierung" nicht nur das Erreichen eines punktförmigen Optimums, sondern auch eine Systemauslegung "nahe bei einem Optimum" verstanden werden. Mit anderen Worten soll jeweils eine Kombination von Parametern erreicht werden, die im Hinblick auf die Mehrzahl von Zielgrößen besonders günstig ist.

Das erfindungsgemäße Computerprogrammprodukt ist direkt in einen programmierbaren Computer ladbar. Es umfasst Programmcodeteile, die dazu geeignet sind, die Schritte des erfindungsgemäßen Verfahrens durchzuführen.

Die Simulationsvorrichtung dient zur computergestützten Simulation einer Mehrzahl von technischen Zielgrößen einer Produktionsmaschine, welche einen Manipulator, wenigstens eine Antriebseinrichtung und wenigstens eine Ansteuerungseinrichtung aufweist. Die Simulationsvorrichtung umfasst
- eine erste Entwicklungsumgebung mit einer darin bereitgestellten ersten Modellkomponente, welche ein oder mehrere mechanische Eigenschaften des Manipulators und/oder der Antriebseinrichtung als Funktion eines ersten Parametersatzes beschreibt,
- eine zweite Entwicklungsumgebung mit einer darin bereitgestellten zweiten Modellkomponente, welche ein oder mehrere physikalische Eigenschaften der Ansteuerungseinrichtung als Funktion eines zweiten Parametersatzes beschreibt,
- und eine Gesamt-Simulationsanwendung, in welcher die erste und die zweite Modellkomponente bereitgestellt sind.

Dabei ist die Gesamt-Simulationsanwendung zur wiederholten Simulation eines Ergebnis-Datensatzes mit einer Mehrzahl von technischen Zielgrößen der Produktionsmaschine auf Basis der Modellkomponenten ausgelegt.

Die Vorteile des erfindungsgemäßen Computerprogrammprodukts und der erfindungsgemäßen Simulationsvorrichtung ergeben sich analog zu den weiter oben beschriebenen Vorteilen des erfindungsgemäßen Verfahrens.

Vorteilhafte Ausgestaltungen und Weiterbildungen der Erfindung gehen aus den von Anspruch 1 abhängigen Ansprüchen sowie der folgenden Beschreibung hervor. Dabei können die beschriebenen Ausgestaltungen des Verfahrens, des Computerprogrammprodukts und der Simulationsvorrichtung allgemein vorteilhaft miteinander kombiniert werden.

So kann das Verfahren allgemein vorteilhaft zusätzlich den folgenden Schritt umfassen:
d) vergleichendes Darstellen der erhaltenen Mehrzahl von Ergebnis-Datensätzen.

Dabei kann jeder Ergebnis-Datensatz insbesondere nur durch einen Teil der simulierten technischen Zielgrößen repräsentiert sein. Es ist also nicht nötig, dass alle berechneten Zielgrößen in der vergleichenden Darstellung enthalten sind. Auch muss nicht jeder der simulierten Ergebnis-Datensätze in der vergleichenden Darstellung gezeigt werden. So kann beispielsweise ein dargestellter Wertebereich durch eine benutzerdefinierte Skala und/oder benutzerdefinierte Schwellwerte eingeschränkt werden, obwohl tatsächlich eine größere Menge von Ergebnis-Datensätzen berechnet wurde. Wesentlich ist also nur, dass zumindest für eine Teilmenge der Ergebnis-Datensätze zumindest eine berechnete technische Zielgröße vergleichend dargestellt wird. Durch eine solche vergleichende Darstellung wird es einem Nutzer des Simulationsverfahrens ermöglicht, unter der Mehrzahl von günstigen Lösungen des Multikriterien-Problems eine oder mehrere besonders vorteilhafte auszuwählen und diese dann als technische Ausgestaltung einer realen Produktionsmaschine umzusetzen.

Die vergleichende Darstellung kann besonders vorteilhaft durch eine Vielzahl von Punkten in einem Punktediagramm erfolgen. Eine solche Punktewolke ermöglicht es dem Nutzer, einen besonders leicht verständlichen Überblick über den Lösungsraum zu erhalten und intuitiv eine nach subjektiven Wertungen der jeweils konkurrierenden Kriterien besonders günstige Lösung auszuwählen. Alternativ zu der Darstellung über eine Punktewolke kann der simulierte Lösungsraum aber auch beispielsweise durch Kurven- oder Flächendiagramme oder ein Hologramm visualisiert werden. Allgemein kann die Visualisierung auch vorteilhaft in einer Augmented Reality Umgebung erfolgen.

Die vergleichende Darstellung kann bevorzugt in einem wenigstens zweidimensionalen Koordinatensystem erfolgen, wobei die wenigstens zwei Koordinaten durch Parameter aus den Parametersätzen der einzelnen Modellkomponenten und/oder durch Zielgrößen gegeben sind. Die vergleichende Darstellung in einem zweidimensionalen Koordinatensystem ist dabei besonders einfach zu realisieren. Es kann aber auch ein dreidimensionales Diagramm dargestellt werden, welches dem Anwender beispielsweise durch interaktive Drehung oder durch Stereo-Ansicht einen Eindruck von der höheren Dimensionalität der Abhängigkeiten ermöglicht. Weiterhin kann eine vergleichende Darstellung bezüglich einer höheren Dimensionalität auch durch ein Sterndiagramm und/oder durch ein Einbeziehen einer Farbe für die Punkte, Kurven oder Flächen als Repräsentation einer physikalischen Größe erreicht werden.

Die zwei oder mehr Koordinaten für die vergleichende Darstellung können zweckmäßig zumindest eine technische Zielgröße umfassen. Sie können allgemein bevorzugt mehrere technische Zielgrößen umfassen, um insbesondere konkurrierenden Kriterien zu visualisieren. Alternativ kann aber auch eine technische Zielgröße mit einer Größe aus einem Parametersatz einer der Modellkomponenten kombiniert werden. Auch dies kann sinnvoll sein, um die komplexen Abhängigkeiten darzustellen. Bei der vergleichenden Darstellung mit einer höheren Dimensionalität können auch mehrere Zielgrößen und/oder mehrere Größen aus den Parametersätzen der Modellkomponenten als Koordinaten dienen. Alternativ oder zusätzlich können die Zielgrößen und/oder die Größen aus den Parametersätzen der Modellkomponenten jeweils auch als Parameter für die Farbwahl oder als Eckwerte für die dargestellten Skalenbereiche dienen. Vor allem die Kombination der Darstellung von Zielgrößen und Eingabe-Parametern ermöglicht eine intuitiv verständliche Visualisierung der simulierten komplexen Zusammenhänge.

Allgemein vorteilhaft kann die Mehrzahl von simulierten technischen Zielgrößen ein oder mehrere Größen aus der folgenden ersten Kriteriengruppe umfassen:
- die Masse der Produktionsmaschine oder einer Teilkomponente der Produktionsmaschine,
- eine maximal tolerierbare Zusatzlast,
- eine Steifigkeit des Manipulators,
- eine maximal im Bereich eines End-Effektors bewirkbare Kraft oder ein maximal bewirkbares Drehmoment,
- ein benötigter Bauraum für die Produktionsmaschine.

Mit anderen Worten wird bei dem Simulationsverfahren zumindest eine technische Zielgröße simuliert, welche überwiegend der mechanischen Domäne zuzuordnen ist. Es handelt sich hier um grundlegende mechanische Zielgrößen des Manipulators und/oder der Antriebseinrichtung. So werden die genannten Zielgrößen aus der ersten Kriteriengruppe vornehmlich oder sogar überwiegend durch die Berechnungen innerhalb der ersten Modellkomponente beeinflusst. Ein Einfluss aus den Berechnungen innerhalb der zweiten Modellkomponente und optional vorhandener weiterer Modellkomponenten auf diese Zielgrößen soll dabei allerdings nicht grundsätzlich ausgeschlossen sein.

Weiterhin vorteilhaft kann die Mehrzahl von simulierten technischen Zielgrößen ein oder mehrere Größen aus der folgenden zweiten Kriteriengruppe umfassen:
- eine Zeitdauer, in der die automatische Produktionsmaschine eine vorgegebene Bewegungs-Trajektorie durchfahren kann,
- ein für das Durchfahren einer vorgegebenen Bewegungs-Trajektorie benötigter Energie-Bedarf,
- eine für das Durchfahren einer vorgegebenen Bewegungs-Trajektorie benötigte Maximal-Leistung.
- eine bei einer vorgegebenen Pose erreichbare Positionierungsgenauigkeit eines End-Effektors der Produktionsmaschine,
- die im Bereich eines End-Effektors der Produktionsmaschine maximal erreichbare Beschleunigung,
- eine Bremszeit für das Abbremsen aus der erreichbaren Maximalgeschwindigkeit eines End-Effektors,
- eine Bremsweg für das Abbremsen aus der erreichbaren Maximalgeschwindigkeit eines End-Effektors,
- eine Frequenz und/oder Amplitude einer Oszillation des End-Effektors,
- eine Dämpfung und/oder Abklingzeit einer Oszillation des End-Effektors.

Die genannten Bewegungs-Trajektorien und Genauigkeiten beziehen sich dabei insbesondere auf die Position eines End-Effektors. Die genannte Positionierungsgenauigkeit kann dabei abhängig vom betrachteten Bewegungsfreiheitsgrad in Ortskoordinaten oder Winkelkoordinaten angegeben werden.

Mit anderen Worten wird bei dieser Ausführungsform wenigstens eine technische Zielgröße simuliert, welche zumindest auch durch die Ansteuerungs-Domäne wesentlich mitbeeinflusst wird.

Allgemein ist es im Zusammenhang mit der vorliegenden Erfindung besonders vorteilhaft, wenn mit der Simulation wenigstens eine Zielgröße aus der ersten Kriteriengruppe und wenigstens eine Zielgröße aus der zweiten Kriteriengruppe berechnet wird. Insbesondere kann mittels der vergleichenden Darstellung die Parameter-Abhängigkeit für zwei solche unterschiedlichen Typen von Zielgrößen gleichzeitig visualisiert werden. Besonders vorteilhaft kann es sich bei der ausgewählten Zielgröße aus der ersten Kriteriengruppe und der ausgewählten Zielgröße aus der zweiten Kriteriengruppe um miteinander konkurrierende Zielgrößen handeln. Eine solche Simulation ermöglicht besonders vorteilhaft eine Abwägung bei der Bewertung von konkurrierenden Zielgrößen, welche durch wenigstens zwei unterschiedliche physikalische Domänen geprägt sind. Hierdurch kommen die Vorteile der Erfindung im Zusammenhang mit einer erleichterten Wahl einer Gesamt-Auslegung der Produktionsmaschine besonders vorteilhaft zur Geltung.

Weiterhin vorteilhaft kann die Mehrzahl von simulierten technischen Zielgrößen ein oder mehrere Größen aus der folgenden dritten Kriteriengruppe umfassen:
- die Herstellungskosten der Produktionsmaschine oder einer ihrer Teilkomponenten,
- der Betriebskosten der Produktionsmaschine bei der Durchführung einer vorgegebenen Handlung.

Derartige Wirtschaftlichkeitskriterien können beispielsweise aufgrund von Datensätzen für die Materialkosten einzelner Komponenten, Arbeitskosten für bestimmte Herstellungsschritte und/oder Energiekosten und Kosten für benötigten Bauraum ermittelt werden. Auch wenn diese Größen nur mit einer relativ hohen Ungenauigkeit bekannt sind, so kann trotzdem in dem ermittelten Lösungsraum durch Ermittlung von Tendenzen die Wirtschaftlichkeit der Produktionsmaschine in Konkurrenz zu den übrigen Performance-Zielen betrachtet und optimiert werden.

Allgemein vorteilhaft kann der erste Parametersatz, welcher in der ersten Modellkomponente berücksichtigt wird, ein oder mehrere der folgenden Parameter umfassen:
- eine Anzahl der Armglieder in einem mehrgliedrigen Manipulator,
- eine Anzahl der rotatorischen Freiheitsgrade in einem mehrgliedrigen Manipulator,
- die Länge(n) von einem oder mehreren Armgliedern des Manipulators,
- die Materialien von einem oder mehreren Armgliedern des Manipulators,
- die mechanischen Steifigkeiten von einem oder mehreren Armgliedern und/oder Armgelenken des Manipulators,
- die Massen von einem oder mehreren Armgliedern und/oder Armgelenken des Manipulators.

Es kann sich hier also insbesondere um grundlegende Auslegungsparameter des mechanischen Systems des Manipulators handeln. Dabei ist allerdings grundsätzlich nicht ausgeschlossen, dass auch andere Parameter - beispielsweise charakteristische Parameter der Antriebseinrichtung und/oder der Ansteuerungseinrichtung auch in der ersten Modellkomponente für die Beschreibung berücksichtigt werden.

Gemäß einer weiteren vorteilhaften Ausführungsform kann die erste Modellkomponente in Schritt a1) ein oder mehrere mechanische Eigenschaften des Manipulators beschreiben, und das Verfahren kann den folgenden zusätzlichen Schritt aufweisen:
- a3) Exportieren einer in einer dritten Entwicklungsumgebung bereitgestellten dritten Modellkomponente, welche ein oder mehrere mechanische und/oder elektromechanische Eigenschaften der wenigstens einen Antriebseinrichtung als Funktion eines dritten Parametersatzes beschreibt.

Mit anderen Worten liegt hier eine zusätzliche dritte Modellkomponente vor, so dass eine Kombination von (wenigstens) drei unterschiedlichen physikalischen Domänen ermöglicht wird. Bei dieser Variante kann die erste Modellkomponente vornehmlich auf die mechanischen Eigenschaften des Manipulators ausgelegt sein, die zweite Modellkomponente vornehmlich auf die Eigenschaften der Ansteuerungseinrichtung und die dritte Modellkomponenten auf die mechanischen und/oder elektromagnetischen Eigenschaften der Antriebseinrichtung. Auf diese Weise können die drei einzelnen Modellkomponenten die Design-Spielräume von drei separaten Expertendomänen bzw. Entwicklerteams abbilden, nämlich die Auslegung des Manipulators, die Auslegung der wenigstens einen Ansteuerungseinrichtung und die Auslegung der wenigstens einen Antriebseinrichtung. Mit Hilfe der Zusammenführung in der Gesamt-Simulationsanwendung und der Betrachtung von wenigstens zwei übergeordneten technischen Zielgrößen kann so das komplexe Zusammenspiel zwischen den Parametern aus diesen einzelnen Entwicklungsdomänen analysiert und optimiert werden. Insbesondere erhält jeder der Domänen-Experten auch einen Einblick in das Optimierungspotential aus den übrigen Domänen und in die Art des Zusammenspiels der Auslegungs-Parameter aus den übrigen Domänen mit den eigenen Auslegungs-Parametern. Solche Zusammenhänge sind anderweitig nur äußerst schwer zu überblicken und eine Optimierung in tatsächlicher Hardware würde eine große Anzahl von aufwendigen Design-Zyklen erfordern.

Bei den Ausführungsformen mit einer dritten Modellkomponente für die Antriebseinrichtung(en) kann der dritte Parametersatz vorteilhaft ein oder mehrere der folgenden Parameter umfassen:
- eine Auswahl aus einem der beiden Antriebstypen Getriebeantrieb oder Direktantrieb,
- eine Leistungsklasse eines Antriebsmotors der Antriebseinrichtung,
- ein Übersetzungsverhältnis eines Getriebes der Antriebseinrichtung
- eine Steifigkeit eines Getriebes und/oder sonstiger Elemente der Antriebseinrichtung,
- eine Masse der Antriebseinrichtung,
- ein benötigter Bauraum der Antriebseinrichtung.

Dies sind Beispiele für wesentliche Auslegungsparameter der wenigstens einen Antriebseinrichtung. Im Falle von mehreren Antriebseinrichtung spielt natürlich auch deren Anzahl und Zuordnung zu den einzelnen mechanischen Bewegungsfreiheitsgraden des Manipulators als Parameter des dritten Parametersatzes eine entscheidende Rolle.

Alternativ können die genannten Parameter der Antriebseinrichtung (en) auch Bestandteil des ersten Parametersatzes sein. Dies gilt insbesondere dann, wenn keine separate dritte Modellkomponente vorliegt, sondern die Eigenschaften der Antriebseinrichtung(en) auch innerhalb der ersten Modellkomponente mit beschrieben werden.

Allgemein können die einzelnen Parameter im ersten, zweiten und optionalen dritten Parametersatz auch prinzipiell miteinander überlappen. So kann beispielsweise ein mechanischer Parameter des Manipulators auch bei der Beschreibung der Wirkung der Ansteuerungseinrichtung(en) Anwendung finden, und entsprechend für die anderen Wechselwirkungen zwischen den einzelnen Modellkomponenten. Allgemein sind die genannten Parametersätze auch nicht auf diskrete Werte von einzelnen physikalischen Größen beschränkt, sondern es können hier komplexe Modelle für geometrische Formen, Materialien und Typen von Ansteuerungen, Antrieben, usw. angegeben werden. Solche Modelle können insbesondere durch Import der entsprechenden Daten in die jeweilige Modellkomponente eingebunden werden.

Allgemein kann der zweite Parametersatz ein oder mehrere der folgenden Parameter umfassen:
- Art des eingesetzten Pfadplanungsalgorithmus,
- Anzahl der für eine angesteuerte Trajektorie verwendeten diskreten Wegpunkte,
- Art und Stärke der Homogenisierung einer Trajektorie zwischen diskreten Wegpunkten,
- Bereiche der in den zulässigen Pfaden erlaubten Gelenkwinkel,
- Anzahl der mittels einer Heuristik untersuchten Lösungen.

Weiterhin ist es allgemein besonders bevorzugt, wenn abhängig von der Wahl des Parametersatzes in einer vorgegebenen Modellkomponente die Wahlmöglichkeiten für den Parametersatzes in einer jeweils anderen Modellkomponente eingeschränkt werden können. So können mit anderen Worten durch die Zusammenführung der einzelnen Modellkomponenten in der Gesamt-Simulationsanwendung aus der Parameterwahl innerhalb einer gegebenen Modellkomponente Restriktionen für die Parameterwahl innerhalb einer anderen Modellkomponente resultieren. Durch eine derartige Restriktion kann beispielsweise bestimmt werden, dass eine vorgegebene Steuerungseinrichtung nur für bestimmte Klassen von Antriebseinrichtungen geeignet ist, oder dass für bestimmte Antriebseinrichtungen innerhalb des Manipulators ein vorgegebener Bauraum zur Verfügung gestellt werden muss.

Gemäß einer weiteren vorteilhaften Ausführungsform wird dem Anwender des computergestützten Verfahrens eine von mehreren Rollen zugewiesen, wobei insbesondere in Abhängigkeit von der zugewiesenen Rolle des Anwenders eine unterschiedliche Variationsmöglichkeit in den einzelnen Parametersätzen ermöglicht wird. So kann insbesondere abhängig von der zugewiesenen Rolle ein Zugriff des Anwenders auf den Parametersatz einer gegebenen Modellkomponente beschränkt werden. Alternativ kann der Zugriff auf die Parametersätze einer Auswahl von Modellkomponenten beschränkt werden. Auf diese Weise kann beispielsweise ein Entwickler des Manipulators ausschließlich Zugriff auf den ersten Parametersatz erhalten, der die wesentlichen mechanischen Eigenschaften des Manipulators bestimmt. In ähnlicher Weise kann ein Entwickler des Antriebssystems ausschließlich Zugriff auf den dritten Parametersatz erhalten, und ein Entwickler des Ansteuerungssystems kann ausschließlich Zugriff auf den zweiten Parametersatz erhalten. Alternativ zu einem sehr stark eingeschränkten Zugriff auf die eigene Domäne kann aber zusätzlich auch ein Zugriff auf die Parametersätze von ein oder mehreren weiteren Modellkomponenten ermöglicht werden. Dieser Zugriff kann aber insbesondere im Vergleich zu den insgesamt vorhandenen Variationsmöglichkeiten für die "domänenfremden" Entwickler auf einen Teilbereich eingeschränkt sein.

Besonders vorteilhaft ist es, wenn bei einer Ausführungsform mit einem rollenabhängigen Zugriff dem Anwender auch in Abhängigkeit von der zugewiesenen Rolle eine unterschiedliche Teilmenge des simulierten Ergebnis-Datensatzes zur Verfügung gestellt wird. So können insbesondere dem Entwickler eines gegebenen Teilsystems zwar die übergeordneten Performance-Daten der gesamten Produktionsmaschine angezeigt werden, aber die Detailinformationen zu den Zielgrößen, die vornehmlich durch die anderen Domänen bestimmt werden, können beispielsweise der besseren Übersicht halber in der vergleichenden Darstellung ausgeblendet sein.

Die automatische Produktionsmaschine kann allgemein ein Roboter oder ein Roboterarm sein bzw. einen Roboter oder einen Roboterarm umfassen. Insbesondere kann es sich bei einem solchen Roboter um einen Industrieroboter handeln. Gerade bei solchen Maschinen kommen die Vorteile der Erfindung im Zusammenhang mit der multi-kriteriellen gleichzeitigen Optimierung von Parametern des Manipulators, des Antriebssystems und des Ansteuerungssystems besonders wirksam zum Tragen.

Nachfolgend wird die Erfindung anhand einiger bevorzugter Ausführungsbeispiele unter Bezugnahme auf die angehängten Zeichnungen beschrieben, in denen:
- Figur 1: eine schematische perspektivische Darstellung einer Produktionsmaschine zeigt,
- Figur 2: ein Ablaufdiagramm für ein Ausführungsbeispiel des Verfahrens zeigt,
- Figur 3: eine Blockdarstellung für eine Simulationsvorrichtung nach einem Beispiel der Erfindung zeigt und
- Figuren 4 und 5: Beispiele für vergleichende Darstellungen einer Mehrzahl von Ergebnis-Datensätzen zeigen.

In den Figuren sind gleiche oder funktionsgleiche Elemente mit gleichen Bezugszeichen versehen.

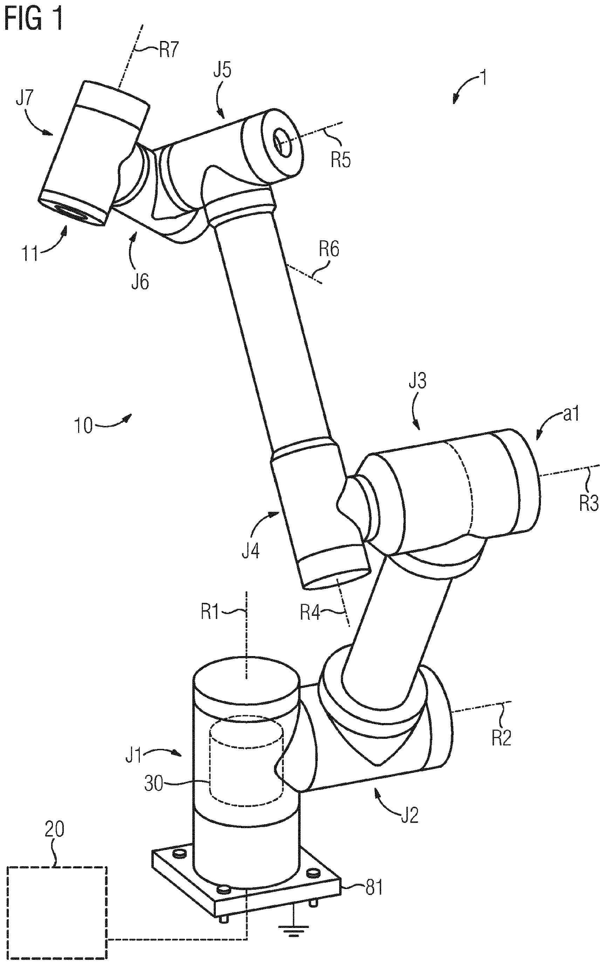

In Figur 1 ist eine schematische perspektivische Darstellung für ein Beispiel einer Produktionsmaschine 1 gezeigt, deren technische Zielgrößen mit dem erfindungsgemäßen Verfahren simuliert werden können. Es handelt sich hier um einen Roboterarm mit sieben Robotikgelenken J1 bis J7, welche jeweils eine Drehung um eine zugehörige Rotationsachse R1 bis R7 ermöglichen. Es handelt sich also um einen Roboterarm mit sieben rotatorischen Freiheitsgraden. Das "innerste" Gelenk J1 ist mit einer Basis 81 verbunden, welche als übergeordnete mechanische Messe dient. Das "äußerste" Gelenk J7 kann einen nicht näher dargestellten Endeffektor tragen, dessen Position hier mit 11 gekennzeichnet ist. Das gesamte mechanische Grundgerüst des Roboterarms bildet hier den Manipulator 10 der Produktionsmaschine.

Innerhalb der einzelnen Gelenke J1 bis J7 ist jeweils eine Antriebseinrichtung angeordnet, von denen hier nur innerhalb des Gelenks J1 eine Antriebseinrichtung 30 beispielhaft skizziert ist. Hier können z.B. Rotationsantriebe zur Drehung der einzelnen Gelenke zum Einsatz kommen, wie sie aus dem Stand der Technik grundsätzlich bekannt sind. Zur automatischen Ansteuerung des Roboterarms weist die Maschine 1 eine Ansteuerungseinrichtung 20 auf, welche ebenfalls nur sehr schematisch dargestellt ist. Sie kann sich, so wie hier angedeutet als zentrale Ansteuerungseinrichtung außerhalb des Manipulators 10 befinden. Alternativ oder zusätzlich zu einer solchen zentralen Einrichtung kann die Ansteuerungseinrichtung aber auch mehrere dezentrale Teilelemente umfassen, welche beispielsweise in die einzelnen Gelenke integriert sein können. In jedem Fall sind zumindest Teile der Ansteuerungseinrichtung(en) mit den einzelnen Antriebseinrichtungen in den Armgelenken kommunizierend verbunden.

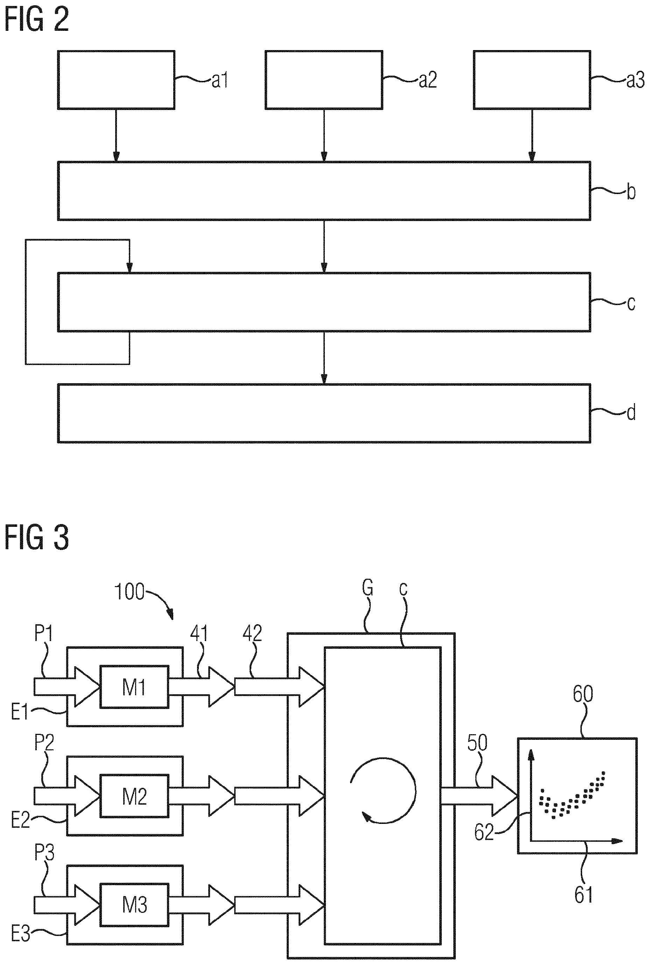

In Figur 2 ist ein Ablaufdiagramm für ein Ausführungsbeispiel des erfindungsgemäßen Verfahrens zur computergestützten Simulation einer Mehrzahl von technischen Zielgrößen einer solchen Produktionsmaschine gezeigt. Figur 3 zeigt eine entsprechende Simulationsvorrichtung 100 zur Durchführung eines solchen Verfahrens.

In Schritt a1 des Verfahrens wird eine erste Modellkomponente bereitgestellt, welche eine oder mehrere mechanische Eigenschaften des Manipulators 10 und/oder der Antriebseinrichtung 30 als Funktion eines ersten Parametersatzes P1 beschreibt. Im Blockdiagramm der Figur 3 ist ersichtlich, dass diese erste Modellkomponente M1 innerhalb einer ersten Entwicklungsumgebung E1 bereitgestellt wird, wobei der erste Parametersatz P1 zur Verfügung gestellt wird. Diese erste Modellkomponente M1 kann beispielsweise durch Export 41 aus der ersten Entwicklungsumgebung E1 zur Verfügung gestellt werden.

In entsprechender Weise wird in Schritt a2 des Verfahrens eine zweite Modellkomponente M2 bereitgestellt, welche eine oder mehrere physikalische Eigenschaften der Ansteuerungseinrichtung 20 als Funktion eines zweiten Parametersatzes P2 beschreibt. Dies geschieht in einer zweiten Entwicklungsumgebung E2.

In einem optionalen dritten Schritt a3 des Verfahrens wird eine dritte Modellkomponente M3 bereitbestellt, welche ein oder mehrere mechanische und/oder elektromagnetische Eigenschaften der wenigstens einen Antriebseinrichtung 30 als Funktion eines dritten Parametersatzes beschreibt. Dies geschieht in einer optionalen dritten Entwicklungsumgebung E3. Wenn dieser optionale Schritt a3 durchgeführt wird, also mit anderen Worten die Antriebseinrichtung in einer separaten Entwicklungsumgebung E3 beschrieben wird, dann reicht es aus, wenn in Schritt a1 in der ersten Modellkomponente im Wesentlichen die mechanischen Eigenschaften des Manipulators beschrieben werden.

In einem weiteren, an diese drei Schritte a1 bis a3 anschließenden Verfahrensschritt b werden die einzelnen Modellkomponenten M1 und M2 sowie die optionale Modellkomponenten M3 gemeinsam in einer Gesamt-Simulationsanwendung G bereitgestellt. Dies kann, wie in Figur 3 angedeutet, beispielsweise durch Import 42 in die Gesamt-Simulationsanwendung G erfolgen.

In einem weiteren Verfahrensschritt c wird ein Ergebnis-Datensatz mit einer Mehrzahl von technischen Zielgrößen der Produktionsmaschine 1 in der Gesamt-Simulationsanwendung G und auf Basis der einzelnen Modellkomponenten M1, M2 und optional auch M3 simuliert. Dieser Schritt c wird mit unterschiedlichen Parametersätzen P1 bis P3 mehrfach wiederholt, so dass für jeden Gesamt-Parametersatz ein zugeordneter Ergebnis-Datensatz mit einer Mehrzahl von technischen Zielgrößen erhalten wird. Dies ist durch das Schleifensymbol angedeutet. Insgesamt wird dadurch eine Mehrzahl 50 von Ergebnis-Datensätzen erhalten.

Diese Mehrzahl 50 von Ergebnis-Datensätzen kann in einem optionalen weiteren Schritt d durch vergleichendes Darstellen in einer Darstellungs-Vorrichtung 60 visualisiert werden. Dies kann insbesondere durch eine Punktewolke in einem wenigstens zweidimensionalen Koordinatensystem erfolgen, mit einer ersten Koordinatenachse 61 und einer zweiten Koordinatenachse 62.

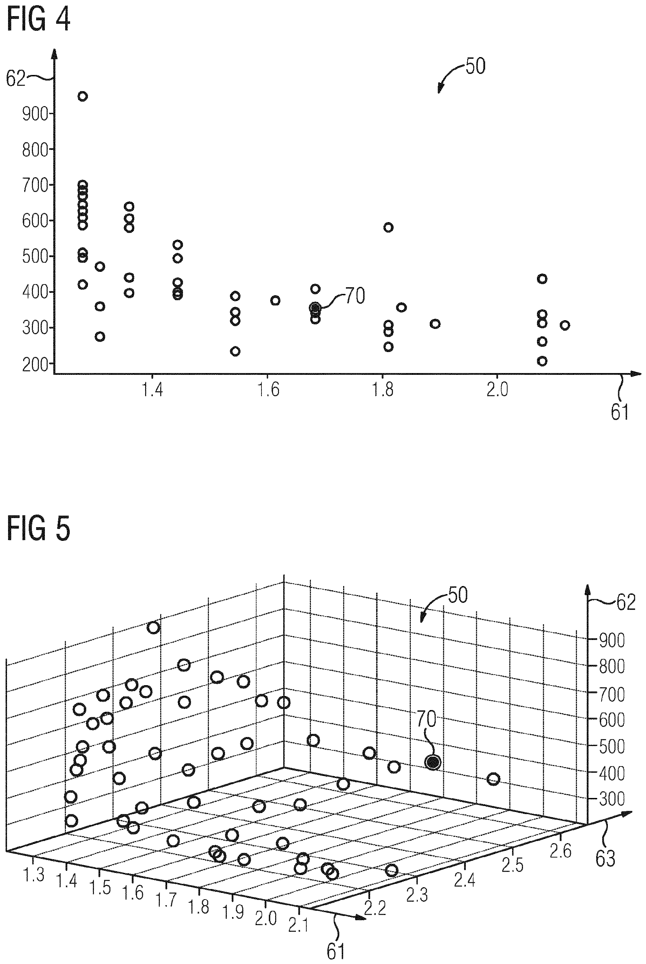

In Figur 4 ist ein Beispiel für eine solche vergleichende Darstellung einer Mehrzahl 50 von Ergebnis-Datensätzen über eine Vielzahl von Punkten in einem zweidimensionalen Punktdiagramm gezeigt. Jeder Ergebnis-Datensatz umfasst dabei sowohl die Parametersätze P1 bis P3 der einzelnen Modellkomponenten als auch die Mehrzahl von technischen Zielgrößen. Diese Mehrzahl von technischen Zielgrößen kann insbesondere auch miteinander konkurrierende Zielgrößen umfassen. Für die Koordinatenachsen der vergleichenden Darstellung können grundsätzlich sowohl Ausgangsparameter aus den Parametersätzen P1 bis P3 als auch technische Zielgrößen gewählt werden. Im Beispiel der Figur 4 ist für die erste Koordinatenachse 61 die Zeitdauer für eine vorgegebene Bewegungs-Trajektorie des End-Effektors in Sekunden gewählt. Für die zweite Koordinatenachse 62 ist die für das Durchfahren der vorgegebenen Bewegungs-Trajektorie benötigte Energie in Joule gewählt. Bei diesen beiden Größen handelt es sich um grundsätzlich miteinander konkurrierende Zielgrößen. Zwischen den einzelnen Punkten der Punkteschar wurden beispielsweise die in den einzelnen Armgelenken einstellbaren Knickwinkel variiert.

Durch eine vergleichende Darstellung der Ergebnis-Datensätze über eine Punkteschar kann ein Anwender eine Übersicht über den Lösungsraum gewinnen. Idealerweise ermöglicht es ein Anklicken eines bestimmten Datenpunkts, weitere Informationen über die zugrundeliegenden Parametersätze P1 bis P3 und weitere in dem Ergebnis-Datensatz enthaltene Zielgrößen zu erhalten. Somit kann ein Entwickler die Einflüsse der Auslegungsparameter des Manipulators, der Antriebseinrichtung und der Ansteuerungsvorrichtung auf die Gesamt-Performance abschätzen und eine nach seinen Bewertungsgrundlagen besonders günstige Lösung aus dem Lösungsraum auswählen. Dies kann beispielsweise einer der Datenpunkte sein, bei welchem eine vergleichsweise niedrige Zeitdauer bei gleichzeitig niedrigem Energieverbrauch erreicht wird.

In Figur 5 ist ein Beispiel für eine vergleichende Darstellung einer Mehrzahl 50 von Ergebnis-Datensätzen über eine Vielzahl von Punkten in einem dreidimensionalen Punktdiagramm gezeigt. Zusätzlich zu den beiden Koordinatenachsen 61 und 62 aus Figur 4 ist hier als dritte Koordinatenachse 63 die über alle Gelenke summierte kartesische Distanz in Metern gewählt. In dieser Darstellung sind somit Dauer, Energie und Weg im Verhältnis zueinander gesetzt, wodurch der Entwickler Trajektorien mit besonders geringem durchschnittlichen Energieverbrauch pro Zeit- und Wegeinheit, sowie Trajektorien mit besonders hoher Durchschnittsgeschwindigkeit und geringer Wegstrecke identifizieren kann. Die dritte Achse ermöglicht es somit einem Entwickler, eine weiter verbesserte Übersicht über den möglichen Lösungsraum in Abhängigkeit von den variablen Parametern zu erreichen. Alternativ zu der dritten Koordinatenachse können Abhängigkeiten in weiteren Dimensionen aber auch durch eine Farbgebung und/oder durch eine unterschiedliche Wahl der Punktsymbole in Abhängigkeit von den Eingabe-Parameter und/oder den erreichten Zielgrößen visualisiert werden. Beispielsweise können unterschiedliche Punktsymbole verwendet werden, je nachdem ob ein sechsachsiger oder ein siebenachsiger Roboter eingesetzt wird oder je nachdem ob ein Direktantrieb oder ein Antrieb mit Getriebe eingesetzt wird.

In allen Fällen ermöglicht es das erfindungsgemäße Verfahren auch einem stark auf eine bestimmte Systemkomponente spezialisierten Entwickler, eine Übersicht über den Gesamt-Lösungsraum zu erhalten, um den Einfluss von Parametern aus der eigenen Domäne aber auch aus den anderen Domänen auf die komplexe, multikriterielle Gesamtoptimierung abschätzen zu können.

## Patentansprüche

1. Computergestütztes Verfahren zur Simulation einer Mehrzahl von technischen Zielgrößen einer Produktionsmaschine (1), welche einen Manipulator (10), wenigstens eine Antriebseinrichtung (30) und wenigstens eine Ansteuerungseinrichtung (20) aufweist,
wobei das Verfahren die folgenden Verfahrensschritte umfasst:
a1) Bereitstellen einer ersten Modellkomponente (M1), welche eine oder mehrere mechanische Eigenschaften des Manipulators (10) und/oder der Antriebseinrichtung (30) als Funktion eines ersten Parametersatzes (P1) beschreibt, in einer ersten Entwicklungsumgebung (E1),
a2) Bereitstellen einer zweiten Modellkomponente (M2), welche eine oder mehrere physikalische Eigenschaften der Ansteuerungseinrichtung (20) als Funktion eines zweiten Parametersatzes beschreibt (P2), in einer zweiten Entwicklungsumgebung (E2),
b) Bereitstellen der ersten und der zweiten Modellkomponente (M1,M2) in einer Gesamt-Simulationsanwendung (G) und
c) Simulation eines Ergebnis-Datensatzes mit einer Mehrzahl der technischen Zielgrößen der Produktionsmaschine (1) in der Gesamt-Simulationsanwendung (G) auf Basis der Modellkomponenten (M1,M2)
- wobei Schritt c) mit unterschiedlichen Parametersätzen (P1,P2) mehrfach wiederholt wird, so dass für jeden Parametersatz (P1,P2) ein zugeordneter Ergebnis-Datensatz mit einer Mehrzahl von technischen Zielgrößen erhalten wird.

2. Verfahren nach Anspruch 1, welches zusätzlich den folgenden Schritt umfasst:
d) vergleichendes Darstellen der erhaltenen Mehrzahl (50) von Ergebnis-Datensätzen, insbesondere als Vielzahl von Punkten in einem Punktdiagramm.

3. Verfahren nach Anspruch 2, bei welchem das Darstellen der erhaltenen Mehrzahl (50) von Ergebnis-Datensätzen in einem wenigstens zweidimensionalen Koordinatensystem erfolgt, wobei die wenigstens zwei Koordinaten durch Parameter aus den Parametersätzen der Modellkomponenten und/oder durch Zielgrößen gegeben sind.

4. Verfahren nach einem der vorhergehenden Ansprüche, bei welchem zu der Mehrzahl von simulierten technischen Zielgrößen ein oder mehrere Größen aus der folgenden ersten Kriteriengruppe gehören:
- die Masse der Produktionsmaschine oder einer Teilkomponente der Produktionsmaschine,
- eine maximale tolerierbare Zusatzlast,
- eine Steifigkeit des Manipulators,
- eine maximal im Bereich eines End-Effektors bewirkbare Kraft oder ein maximal bewirkbares Drehmoment,
- ein benötigter Bauraum für die Produktionsmaschine.

5. Verfahren nach einem der vorhergehenden Ansprüche, bei welchem zu der Mehrzahl von simulierten technischen Zielgrößen ein oder mehrere Größen aus der folgenden zweiten Kriteriengruppe gehören:
- eine Zeitdauer, in der die automatische Produktionsmaschine eine vorgegebene Bewegungs-Trajektorie durchfahren kann,
- ein für das Durchfahren einer vorgegebenen Bewegungs-Trajektorie benötigter Energie-Bedarf,
- eine für das Durchfahren einer vorgegebenen Bewegungs-Trajektorie benötigte Maximal-Leistung.
- eine bei einer vorgegebenen Pose erreichbare Positionierungsgenauigkeit eines End-Effektors (11) der Produktionsmaschine,
- die im Bereich eines End-Effektors (11) der Produktionsmaschine maximal erreichbare Beschleunigung,
- eine Bremszeit für das Abbremsen aus der erreichbaren Maximalgeschwindigkeit eines End-Effektors (11),
- eine Bremsweg für das Abbremsen aus der erreichbaren Maximalgeschwindigkeit eines End-Effektors (11),
- eine Frequenz und/oder Amplitude einer Oszillation des End-Effektors (11),
- eine Dämpfung und/oder Abklingzeit einer Oszillation des End-Effektors (11).

6. Verfahren nach einem der vorhergehenden Ansprüche, bei welchem der erste Parametersatz (P1) ein oder mehrere der folgenden Parameter umfasst:
- eine Anzahl der Armglieder in einem mehrgliedrigen Manipulator (10),
- eine Anzahl der rotatorischen Freiheitsgrade (R1-R7) in einem mehrgliedrigen Manipulator (10),
- die Länge(n) von einem oder mehreren Armgliedern des Manipulators,
- die Materialien von einem oder mehreren Armgliedern des Manipulators,
- die mechanischen Steifigkeiten von einem oder mehreren Armgliedern und/oder Armgelenken (J1-J7) des Manipulators (10),
- die Massen von einem oder mehreren Armgliedern und/oder Armgelenken (J1-J7) des Manipulators.

7. Verfahren nach einem der vorhergehenden Ansprüche,
bei welchem die in erste Modellkomponente (M1) in Schritt a1) ein oder mehrere mechanische Eigenschaften des Manipulators (10) beschreibt,
und welches den folgenden zusätzlichen Schritt aufweist:
a3) Exportieren einer in einer dritten Entwicklungsumgebung (E3) bereitgestellten dritten Modellkomponente (M3), welche ein oder mehrere mechanische und/oder elektromagnetische Eigenschaften der wenigstens einen Antriebseinrichtung (30) als Funktion eines dritten Parametersatzes (P3) beschreibt.

8. Verfahren nach Anspruch 7, bei welchem der dritte Parametersatz (P3) ein oder mehrere der folgenden Parameter umfasst:
- eine Auswahl aus deinem der beiden Antriebstypen Getriebeantrieb oder Direktantrieb,
- eine Leistungsklasse eines Antriebsmotors der Antriebseinrichtung,
- ein Übersetzungsverhältnis eines Getriebes der Antriebseinrichtung
- eine Steifigkeit eines Getriebes und/oder sonstiger Elemente der Antriebseinrichtung,
- eine Masse der Antriebseinrichtung,
- ein benötigter Bauraum der Antriebseinrichtung.

9. Verfahren nach einem der vorhergehenden Ansprüche, bei welchem der zweite Parametersatz (P2) ein oder mehrere der folgenden Parameter umfasst:
- Art des eingesetzten Pfadplanungsalgorithmus,
- Anzahl der für eine angesteuerte Trajektorie verwendeten diskreten Wegpunkte,
- Art und Stärke der Homogenisierung einer Trajektorie zwischen diskreten Wegpunkten,
- Bereiche der in den zulässigen Pfaden erlaubten Gelenkwinkel,
- Anzahl der mittels einer Heuristik untersuchten Lösungen.

10. Verfahren nach einem der vorhergehenden Ansprüche, bei welchem abhängig von der Wahl des Parametersatzes (P1,P2,P3) in einer vorgegebenen Modellkomponente (M1,M2,M3) die Wahlmöglichkeiten für den Parametersatzes in einer jeweils anderen Modellkomponente eingeschränkt werden können.

11. Verfahren nach einem der vorhergehenden Ansprüche, wobei dem Anwender des computergestützten Verfahrenes eine von mehreren Rollen zugewiesen wird,
wobei insbesondere in Abhängigkeit von der zugewiesenen Rolle des Anwenders eine unterschiedliche Variationsmöglichkeit in den einzelnen Parametersätzen (P1,P2,P3) ermöglicht wird.

12. Verfahren nach Anspruch 11, bei dem in Abhängigkeit von der zugewiesenen Rolle dem Anwender eine unterschiedliche Teilmenge des simulierten Ergebnis-Datensatzes zur Verfügung gestellt wird.

13. Verfahren nach einem der vorhergehenden Ansprüche, bei welchem die automatische Produktionsmaschine (1) ein Roboter oder ein Roboterarm ist.

14. Computerprogrammprodukt, das direkt in einen programmierbaren Computer ladbar ist, umfassend Programmcodeteile, die dazu geeignet sind, die Schritte des Verfahrens nach einem der Ansprüche 1 bis 13 durchzuführen.

15. Simulationsvorrichtung (100) zur computergestützten Simulation einer Mehrzahl von technischen Zielgrößen einer Produktionsmaschine (1), welche einen Manipulator (10), wenigstens eine Antriebseinrichtung (30) und wenigstens eine Ansteuerungseinrichtung (20) aufweist,
wobei die Simulationsvorrichtung
- eine erste Entwicklungsumgebung (E1) mit einer darin bereitgestellten ersten Modellkomponente (M1) umfasst, welche ein oder mehrere mechanische Eigenschaften des Manipulators (10) und/oder der Antriebseinrichtung (30) als Funktion eines ersten Parametersatzes (P1) beschreibt,
- eine zweite Entwicklungsumgebung (E2) mit einer darin bereitgestellten zweiten Modellkomponente (M2) umfasst, welche ein oder mehrere physikalische Eigenschaften der Ansteuerungseinrichtung (20) als Funktion eines zweiten Parametersatzes (P2) beschreibt,
- und eine Gesamt-Simulationsanwendung (G) umfasst, in welcher die erste und die zweite Modellkomponente (M1,M2) bereitgestellt sind,
- wobei die Gesamt-Simulationsanwendung (G) zur wiederholten Simulation eines Ergebnis-Datensatzes mit einer Mehrzahl von technischen Zielgrößen der Produktionsmaschine (1) auf Basis der Modellkomponenten (M1,M2) ausgelegt ist.
